# EUROPEAN PATENT APPLICATION

(11) **EP 1 753 032 A1**
(43) Date of publication of application: **14.02.2007**
(21) Application number: 05743744.4
(22) Date of filing: 26.05.2005
(51) Int. Cl.: H01L 31/04, H01L 21/306

(54) **SEMICONDUCTOR SUBSTRATE FOR SOLAR CELL, METHOD FOR MANUFACTURING THE SAME, AND SOLAR CELL**

(30) Priority: 28.05.2004 JP 2004159721
(71) Applicant: SHARP KABUSHIKI KAISHA, Osaka-shi, Osaka 545-8522 (JP)
(72) Inventor: KOMATSU, Yuji, 1816 EE Alkmaar (NL); FUKUMURA, Hiroyuki, Yamatotakada-shi, Nara 6350044 (JP); TAKABA, Yoshiroh, Shiki-gun, Nara 6360202 (JP); OZAKI, Ryoh, Katsuragi-shi, Nara 6392122 (JP); NUNOI, Tohru, Nara 6310804 (JP)
(74) Representative: Müller, Frithjof E.
(86) International application number: PCT/JP2005/009675
(87) International publication number: WO 2005/117138

(57) **Abstract**

A semiconductor substrate for a solar cell, comprising the semiconductor substrate having a surface which constitutes a light incident face of the solar cell and having a surface irregularities structure, wherein the surface has an surface area from 1.2 to 2.2 times that of an imaginary smooth face and the standard deviation of the heights of the irregularities is 1.0 µm or less.

## Description

### TECHNICAL FIELD

The present invention relates to a semiconductor substrate for a solar cell, a method for manufacturing the same, and a solar cell. More specifically, the present invention relates to a semiconductor substrate for a solar cell having a reduced light reflectivity, a method for manufacturing the same at low cost, and a high-performance solar cell manufactured by use of the method.

### BACKGROUND ART

Solar cells wherein pn junctions are formed in a semiconductor substrate, such as a single crystalline silicon substrate or a polycrystalline silicon substrate, are main current solar cell products.

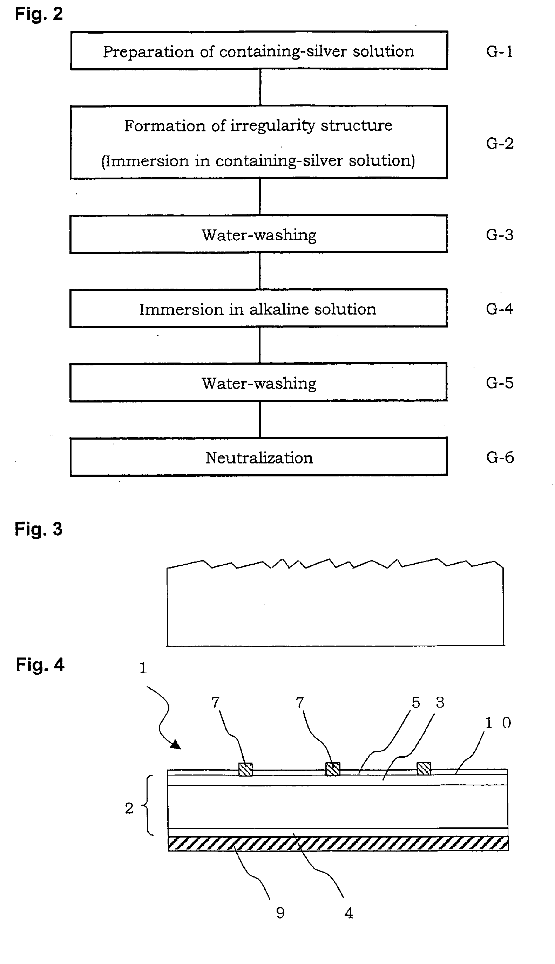

Fig. 4 is a schematic cross-sectional view of a polycrystalline silicon solar cell. This polycrystalline silicon solar cell 1 is manufactured, for example, as follows. First, a silicon ingot manufactured by a casting method is sliced by a multi-wire method, so as to obtain a p-type silicon substrate 2. Next, at least the whole of the light-receiving face of the p-type silicon substrate 2 is chemically treated with an aqueous alkaline solution to make fine irregularities (height: about 10 µ m). Next, an impurity is diffused to the side of a light-receiving face of the p-type silicon substrate 2 by a thermal diffusion method, so as to form an n-type diffusion layer 3. A TiO₂ or SiN film having a film thickness of about 800 Å is formed, as an antireflection film, on the surface of the n-type diffusion layer 3. Next, a material made mainly of aluminum is printed over the substantially entire rear face of the p-type silicon substrate 2, and then fired, thereby forming a rear face electrode 4. Next, a light-receiving face electrode 7 is formed by printing using a silver paste for electrodes. The pattern form of the light-receiving electrode 7 is composed of thin line portions having a width of about 200 µm (referred to as grid electrodes hereinafter), and thick line portions having a width of about 2 mm (not illustrated).

By the formation of the grid electrodes, a large quantity of light can be radiated onto the silicon surface. Through the above-mentioned steps, the polycrystalline silicon solar cell 1 is obtained. The reference number 9 represents a base.

The following will describe a detailed structure of a surface vicinity 101 at the side of a light-receiving face in the polycrystalline silicon solar cell.

Fig. 3 is an enlarged schematic view of the surface vicinity at the light-receiving face side in the polycrystalline silicon solar cell. The surface of the n-type diffusion layer 3, that is, the silicon substrate surface at the side of light incidence microscopically has a form of irregularities having heights from 1 to 10 µ m. The surface form thereof, which is varied by the crystal orientation, basically has an irregularity structure wherein straight lines and planes microscopically get together.

In order to realize a high-efficiency solar cell, it is essential that in a crystalline silicon solar cell an irregularity structure is formed in a surface of a silicon substrate to reduce the reflectivity of light on the surface. Hitherto, therefore, various techniques have been suggested.

About any single crystalline silicon solar cell, in its surface, a structure of fine pyramidal irregularities, called a texture structure, is generally formed by isotropic etching with an aqueous alkaline solution (such as an aqueous solution of sodium hydroxide).

Light that is radiated into the solar cell and then reflected on the front face of the silicon substrate is again hit on a concave in another surface portion by the texture structure, whereby the light penetrates effectively into the solar cell. Light that reaches the rear face of the silicon substrate without being absorbed into the solar cell is reflected on the rear face so as to reach the front face again. The light is again reflected on an inclined plane of the front face and then penetrates into the solar cell. In this way, the light radiated into the solar cell is confined inside the solar cell, and is absorbed without waste, whereby a high-efficiency solar cell is realized.

The above-mentioned technique is a technique of forming the texture structure by use of such a difference in etching rate between crystal orientations that the etching rate of single crystalline silicon with an aqueous alkaline solution is largest for its (100) face and is smallest for its (111) face.

Thus, according to this technique, a sufficient texture structure as obtained in single crystalline silicon cannot be obtained in polycrystalline silicon having, in its faces, various crystal orientations. In other words, in polycrystalline silicon, the orientation of the substrate surface which becomes a light-receiving face of a solar cell is varied by crystal grains therein; thus, there exist crystal grains wherein pyramids of a texture structure are beautifully formed as seen in their (100) faces while there exist flat crystal grains wherein an irregularity structure is hardly formed as seen in their (111) faces. For this reason, for polycrystalline silicon, there have been investigated various techniques for forming an irregularity structure apart from etching with an aqueous alkaline solution, which is used for single crystalline silicon.

Japanese Examined Patent Publication No. HEI 7(1995)-105518 (Patent Document 1) discloses a technique for forming an irregularity structure having a V-shaped cross section (V grooves) mechanically in a surface of a polycrystalline silicon substrate (Technique 1). This technique is a technique of bringing rotating blades having tips in which a material harder than silicon, such as diamond, is embedded into contact with a silicon substrate so as to make V grooves in a surface of the substrate, and adjusting the pitch of the V grooves by the interval between the blades.

Japanese Unexamined Patent Publication No. 2003-101051 (Patent Document 2) discloses a technique for forming a structure of pyramidal irregularities in a surface of a polycrystalline silicon substrate by an etching method called RIE (Reactive Ion Etching) (Technique 2). This technique is a technique of causing silicon in a surface of a polycrystalline silicon substrate to react with chlorine ions and chlorine radicals generated by plasma under a reduced pressure, thereby vaporizing and removing silicon as chlorides so as to form an irregularity structure in the substrate surface.

Furthermore, as a technique for forming a surface irregularity structure of polycrystalline silicon, a chemical technique (Technique 3) as described below has been investigated.

Japanese Unexamined Patent Publication No. HEI 9(1997)-167850 (Patent Document 3) discloses a technique of using an oxidizing solution containing fluorine ions to oxidize some portions of a surface of a polycrystalline silicon substrate chemically to form a porous layer, and dissolving this layer to form concaves having a regular shape regardless of the crystal orientation, the concave being called pits.

Japanese Unexamined Patent Publication No. HEI 10-303443 (Patent Document 4) discloses a method of treating a surface of a semiconductor substrate with a mixed acid composed of nitric acid and hydrofluoric acid to which phosphoric acid or carboxylic acid, which becomes an agent for adjusting etching rate, is added or a mixed acid composed of nitric acid and hydrofluoric acid to which a surfactant is added. The semiconductor substrate surface treated by this method is composed of irregular planes wherein fine spherical concaves gather with a measure of regularity.

Kazuya Tsujino et al.,"Texturization of Polycrystalline Silicon Wafers by Chemical Treatment Using Metallic Catalyst", Third World Conference on Photovoltaic Energy Conversion (WCPEC-3), May 11th-18th, 2003, Osaka in Japan, 4-LN-D-08 (Non-Patent Document 1) describes a technique of forming an irregularity structure, using a catalytic effect based on silver particles deposited on a polycrystalline silicon substrate.

R. Einhaus et al., "Isotropic Texturing of Polycrystalline Silicon Wafers with Acidic Texturing Solutions", 26th IEEE Photovoltaic Specialists Conference (26th IEEE PVSC), 30th September to 3rd October, 1997, Anaheim, CA in USA, conference minutes, pp. 167-170 (Non-Patent Document 2), and A. Hauser et al., "A Simplified Process for Isotropic Texturing of mc-Si", Third World Conference on Photovoltaic Energy Conversion (WCPEC-3), May 11th-18th, 2003, Osaka in Japan, 4P-C4-33 (Non-Patent Document 3) discloses a technique of etching a polycrystalline silicon substrate in which damage generated in slicing process remains with hydrofluoric acid and nitric acid while controlling chemical reaction conditions such as the concentrations of these acids, temperature and time, thereby forming irregularities on a surface of the substrate.

Isotropic texturing method obtained by improving this technique has been put into practical use by RENA Sondermaschinen GMBH in Germany.
Patent Document 1: Japanese Examined Patent Publication No. HEI 7(1995)-105518
Patent Document 2: Japanese Unexamined Patent Publication No. 2003-101051
Patent Document 3: Japanese Unexamined Patent Publication No. HEI 9(1997)-167850
Patent Document 4: Japanese Unexamined Patent Publication No. HEI 10-303443
Non-Patent Document 1: Kazuya Tsujino et al.,"Texturization of Polycrystalline Silicon Wafers by Chemical Treatment Using Metallic Catalyst", Third World Conference on Photovoltaic Energy Conversion (WCPEC-3), May 11th-18th, 2003, Osaka in Japan, 4-LN-D-08
Non-Patent Document 2: R. Einhaus et al., "Isotropic Texturing of Polycrystalline Silicon Wafers with Acidic Texturing Solutions", 26th IEEE Photovoltaic Specialists Conference (26th IEEE PVSC), 30th September to 3rd October, 1997, Anaheim, CA in USA, conference minutes, pp. 167-170
Non-Patent Document 3: A. Hauser et al., "A Simplified Process for Isotropic Texturing of mc-Si", Third World Conference on Photovoltaic Energy Conversion (WCPEC-3), May 11th-18th, 2003, Osaka in Japan, 4P-C4-33

### DISCLOSURE OF THE INVENTION

### Problems that the Invention is to Solve

The above Technique 1 can attain a high-performance reduction in reflection on a polycrystalline silicon substrate, but has a problem that the mass productivity thereof is poor since treatment for each of silicon substrates is necessary and further necessary is the treatment such as a wet etching for removing defects formed at the same time when V-grooves are formed. Furthermore, the V-grooves cannot be formed at very small intervals since the pitch of the V-grooves is restricted by the pitch of rotating blades; thus, the technique has a problem that it is indispensable to form deep V-grooves in order to obtain an effective light-confining effect.

Also, the above Technique 2 has a problem that the mass producing power thereof is poor since the processing capacity is low because of the use of a vacuum process machine and costs for treatment of exhaust gas is high.

Further, the above Technique 3 has a problem that the effect of reducing the optical reflectivity of a semiconductor substrate is insufficient.

The isotropic texturing method put into practical use by RENA Sondermaschinen GMBH is a method about which only low costs are necessary. The surface area of a surface irregularity structure formed in a polycrystalline silicon substrate is from 1.2 to 1.7 times larger than the base area thereof. The grain sizes of the irregularities are from 3 to 5 µ m, and thus the standard deviation of the heights thereof becomes larger than 1.0 µm. When electrodes having a width of 50 µm or less are formed on a surface of a polycrystalline silicon substrate having such irregularities, the shapes of the electrodes are distorted by the effect of the irregularities, so that the electric resistances of the electrodes increase. As a result, a solar cell manufactured by use of such a polycrystalline silicon substrate has a problem that characteristics thereof are deteriorated.

The isotropic texturing method is a method of using the surface state of a polycrystalline silicon substrate damaged in slicing process as a standard to form a surface irregularity structure by chemical etching. Accordingly, the method has a problem that in such a substrate, from which a damage layer is removed, a surface irregularity structure is not sufficiently formed. Additionally, the states of damage layers formed by slicing process are not constant. Therefore, there also arises a problem that when such polycrystalline silicon substrates are treated by the above-mentioned method, a scattering in qualities of products is amplified.

An object of the present invention is to provide a semiconductor substrate for a solar cell having a reduced light reflectivity, a method for manufacturing the semiconductor substrate for solar cell capable of attaining mass production at low costs without depending on the states of substrates; and a high-performance solar cell which is manufactured by the method and has a higher photoelectric conversion property.

### Means for Solving the Problems

The inventors have made eager researches to solve the above-mentioned problems, and found out the following:
(1) As a semiconductor substrate for a solar cell having a low light reflectivity, useful is a semiconductor substrate having a surface which constitutes a light incident face of the solar cell and having a surface irregularities structure, wherein the surface has an surface area from 1.2 to 2.2 times that of an imaginary smooth face and the standard deviation of the heights of the irregularities is 1.0 µm or less.
(2) Whether or not a damage layer formed when a substrate is slicing-processed from a semiconductor ingot is removed, the above-mentioned semiconductor substrate for a solar cell can be obtained by subjecting the substrate successively to immersing treatment in an acid solution containing silver ions or copper ions, fluoride ions, and nitrate ions, water-washing treatment, immersing treatment in an alkaline solution, and water-washing treatment. Thus, the present invention has been made.

Thus, according to the present invention, provided is a semiconductor substrate for a solar cell, comprising the semiconductor substrate having a surface which constitutes a light incident face of the solar cell and having a surface irregularities structure, wherein the surface has an surface area from 1.2 to 2.2 times that of an imaginary smooth face and the standard deviation of the heights of the irregularities is 1.0 µm or less.

Furthermore, according to the present invention, provided is a solar cell manufactured by use of the above-mentioned semiconductor substrate for the solar cell.

Additionally, according to the present invention, provided is a method for manufacturing a semiconductor substrate for a solar cell, comprising the step of subjecting the semiconductor substrate successively to immersing treatment in an acid solution containing silver ions or copper ions, fluoride ions, and nitrate ions, water-washing treatment, immersing treatment in an alkaline solution, and water-washing treatment, thereby obtaining the above-mentioned semiconductor substrate for the solar cell.

### Effects of the Invention

According to the present invention, provided can be a semiconductor substrate which has an in-plane distribution of low light reflectivities and small light reflectivities and is useful for a solar cell, and a method for manufacturing the same. In the solar cell manufactured by use of the semiconductor substrate for solar cell of the present invention, the photoelectric conversion efficiency is made better by 0.5 to 0.9 point and the power output is made better by 2 to 10% than in the solar cell manufactured by use of the semiconductor substrate manufactured by alkali etching method or the isotropic texturing method, which is a conventional method.

When the semiconductor substrate for solar cell of the present invention is a polycrystalline silicon substrate, the surface thereof exhibits a homogenous surface color similar to that of the single crystalline silicon substrate subjected to a conventional treatment.
Thus, this is excellent as a semiconductor substrate for a solar cell.

### BRIEF DESCRIPTION OF THE DRAWINGS

Fig. 1 is a process flowchart of a solar cell production.
Fig. 2 is a process flowchart of formation of an irregularity structure in the present invention.
Fig. 3 is an enlarged schematic view of a surface vicinity at the side of a light-receiving face in a polycrystalline silicon solar cell.
Fig. 4 is a schematic cross-sectional view of a polycrystalline silicon solar cell.
Fig. 5 is a graphic showing a typical bird's eye observation image of a surface of a polycrystalline silicon substrate of group A (Example 1).
Fig. 6 is a graphic showing a typical bird's eye observation image of a surface of a polycrystalline silicon substrate of group B (Example 1).
Fig. 7 is a graphic showing a typical bird's eye observation image of a surface of a polycrystalline silicon substrate of group C (Example 1).

### Explanation of Reference Numbers

1 Solar cell (polycrystalline silicon solar cell)
2 Semiconductor substrate (p-type silicon substrate 2)
3 Impurity diffusion layer (n-type diffusion layer)
4 Rear face electrode
5 Antireflection film
7 Light-receiving electrode
9 Base
101 Surface vicinity at the side of a light-receiving face

### BEST MODE FOR CARRYING OUT THE INVENTION

The semiconductor substrate for solar cell of the present invention is characterized in that its surface which constitutes a light incident face of a solar cell has:
a surface irregularity structure wherein the surface area containing irregularities is from 1.2 to 2.2 times the surface area of the imaginary smooth face and the standard deviation of the heights of the irregularities is 1.0 µ m or less; or a surface irregularity structure wherein aggregate sections of irregularities having irregularity heights ranging from 0.1 to 2 µ m are mixed with sections having irregularity heights ranging from 5 to 20 µ m.

The "surface area containing irregularities" and the "standard deviation of the heights of the irregularities" of the semiconductor substrate in the present invention can be measured by use of a confocal laser scanning microscope using a semiconductor laser light having a wavelength of 408 nm, such as a microscope, model No. LEXT OLS3000, manufactured by Olympus Corporation.

First, from a surface of a semiconductor substrate, 9 to 25 points are selected at will.
The above-mentioned microscope with an objective lens of 100 magnifications is used under 1-power optical zooming in an enhancing mode to take in height data on its surface irregularities in a step search manner at a height resolving power of 0.01 µm. The resultant height data on the irregularities are subjected to smoothing correction one time along an XY direction in a median mode with a mask size of 5. In this way, measurement noises are removed. In accordance with a grain analysis menu, the "surface area containing irregularities" and the "surface area of the imaginary smooth face" are obtained, and in accordance with a surface roughness menu, the "standard deviation (SRq) of the heights of the irregularities" is obtained. These operations are repeated about the 9-25 measured points. The respective averages of the resultant numerical values are used as the "surface area containing irregularities", the "surface area of the imaginary smooth face", and the "standard deviation (SRq) of the heights of the irregularities"

The effectiveness of the semiconductor substrate for solar cell of the present invention is described.

In a semiconductor substrate which becomes a light incident face of a solar cell, sections where no electrode is formed (electrode-unformed sections) occupies 85 to 96% of the whole.

When the surface area containing irregularities in this electrode-unformed sections is from 1.2 to 2.2 times, preferably from 1.3 to 1.6 times the surface area of the imaginary smooth face, the reflection of incident light is restrained so that the incident light can be effectively taken in. When the standard deviation of the heights of the irregularities is 1.0 µm or less, more preferably 0.7 µm or less, the irregularities, which underlie linear grid electrodes that are formed on the surface of the irregularities and each have a width of 5 to 200 µm and a height being from 0.1 to 0.5 times the width, become fine so that the electric resistance against electric current flowing the electrodes can be lowered. The lower limit of the standard deviation of the heights of the irregularities is about 0.1 µm.

The solar cell manufactured by use of such a semiconductor substrate has an improved power generation performance and a higher photoelectric conversion property.

The method for manufacturing a semiconductor substrate for a solar cell of the present invention is described. Numerical values about processing conditions and so forth that are described herein are typical examples. Thus, they never limit the present invention.

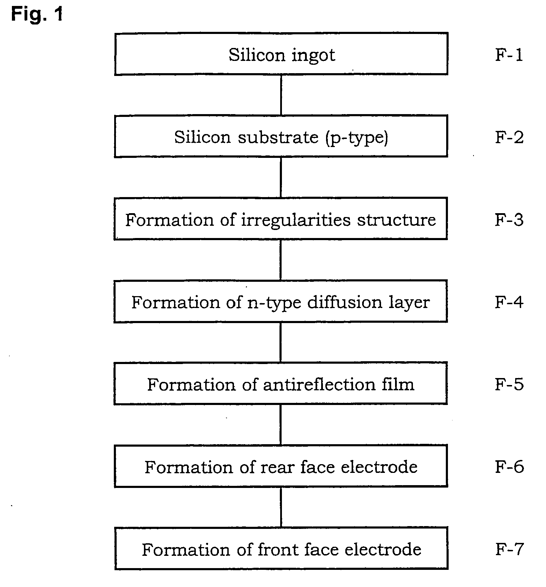

Fig. 1 is a process flowchart of a typical solar cell production, which is ordinarily used for a polycrystalline silicon solar cell or the like.

With reference to Fig. 1, a silicon ingot (F-1) which is manufactured by the FZ method, the CZ method, the casting method or the like and has semiconductor property is sliced by a multi-wire method or the like, so as to obtain a p-type silicon substrate (F-2). Next, irregularities are made in at least a light incident side surface of the p-type silicon substrate (F-3). Subsequently, phosphorus, arsenic or the like is diffused as an impurity into a surface of the silicon substrate so as to give a concentration of 1 x 10¹⁸ to 1 x 10²¹, thereby forming an n-type diffusion layer (F-4). An antireflection film made of SiN, TiO₂ or the like and having a film thickness of about 0.05 to 0.15 µ m is formed thereon (F-5), and a rear face electrode made of aluminum, silver, or the like and having a film thickness of about 1 to 60 µm is formed (F-6). A front face electrode made of titanium, silver or the like and having a film thickness of about 1 to 60 µ m is formed (F-7), so as to complete a solar cell.

The above-mentioned steps can be carried out by a known method. The order thereof may be changed, and a vacuum process may be partially used therein.

The semiconductor substrate may be single crystalline or polycrystalline. The crystal orientation of single crystalline silicon obtained by the FZ method and CZ method may be any orientation. Needless to say, the crystal orientation of polycrystalline silicon obtained by the casting method is at random for every crystal grain.

The semiconductor substrate may be of a p-type or an n-type. In the case that an n-type silicon substrate is used, a p-type diffusion layer should be formed in the step (F-4).

The method for manufacturing a semiconductor substrate for a solar cell of the present invention can be most preferably applied to polycrystalline silicon substrates; however, irregularities can be formed in single crystalline silicon substrates.

The method for manufacturing a semiconductor substrate for a solar cell of the present invention corresponds to the step (F-3), and the step is shown in a process flowchart for forming an irregularity structure in Fig. 2.

Next, on the basis of Fig. 2, the method for manufacturing a semiconductor substrate for a solar cell of the present invention is described. Numerical values about processing conditions and so forth that are described herein are typical examples. Thus, they never limit the present invention.

The silicon substrate sliced in the previous step (F-2) is usually treated with an aqueous acidic solution or an aqueous alkaline solution to remove a fracture layer (residues from slicing) on the substrate surface chemically. The removed thickness, which depends on conditions for the slicing, is generally from 5 to 20 µm. However, even if the fracture layer is present on the substrate surface, the method for manufacturing a semiconductor substrate for a solar cell of the present invention can be applied thereto.

First, an acidic solution (containing silver or copper) is manufactured (prepared) (G-1). Fig. 2 shows a case of the silver-containing solution.

The acidic solution is a solution containing silver ions or copper ions, fluoride ions, and nitrate ions. For example, the acidic solution can be obtained by dissolving 60 cc of a 60% nitric acid solution and 0.5 g of pure silver powder into 2 liters of a 50% hydrofluoric acid solution at room temperature.

The mol concentration of silver in the silver-containing solution ranges from 1 x 10⁻⁶ to 1 x 10⁻² mol/L, preferably from 1 x 10⁻⁵ to 1 x 10⁻³ mol/L.

When copper ions are used instead of the silver ions, the mass of copper should be about 2.5 times the mass of silver. The mol concentration of silver in the copper-containing solution ranges from 1 x 10⁻⁶ to 1 x 10⁻² mol/L, preferably from 1 x 10⁻⁵ to 1 x 10⁻³ mol/L.

When such an acidic solution is used, obtained is an excellent effect of reducing the light reflectivity of the semiconductor substrate. Other conditions, such as the concentration of the solution, should be appropriately set.

The acidic solution is preferably an aqueous solution further containing one or more species selected from acetate ions, sulfate ions, and phosphate ions.

When the acidic solution contains acetate ions, the reaction rate is restrained so that irregularities can be formed in the surface of the semiconductor substrate with a good control.

When the acidic solution contains sulfate ions or phosphate ions, the viscosity of the aqueous solution becomes high so that the irregularity shapes formed in the surface of the semiconductor substrate can be made gentler. This causes an improvement in the contact resistance with electrodes formed by printing and firing.

Next, the semiconductor substrate is immersed in the resultant acidic solution to form a surface irregularity structure of the present invention in the semiconductor substrate (G-2). This step is an isotropic etching with an acid.

It is advisable to set conditions for the immersion appropriately. For example, the silicon substrate is immersed in the acidic solution for 5 minutes.

Next, the semiconductor substrate is taken out from the acidic solution, and then washed sufficiently with water (G-3).

It is advisable to set conditions for the water-washing appropriately. For example, the silicon substrate taken out from the acidic solution is washed with water for about 3 minutes. The surface of the silicon substrate washed with water changes from silvery white, which is an original color of silicon, to black, which is optically high in light absorption. In the present invention, this layer is referred to as a "stain layer", "stain film", "silicon porous layer" or "porous layer".

The inventors of the present invention have observed the stain layer with an electron microscope. As a result, ascertained have been crepe-pattern irregularities wherein the width and the depth are each from 0.1 to 10 µm inwards from the surface of the silicon substrate.

The same acidic solution as described above with the exception of containing neither silver ions nor copper ions has been used to treat the silicon substrate. As a result, irregularities effective for reducing the light reflectivity of the surface of the silicon substrate have not been formed.

Next, the semiconductor substrate is immersed in an alkaline solution to remove the stain layer (G-4).

The alkaline solution is preferably an aqueous solution containing one or more selected from sodium hydroxide, potassium hydroxide, ammonium hydroxide, hydrazine, sodium carbonate and potassium carbonate. When the semiconductor substrate is polycrystalline silicon, an aqueous sodium hydroxide solution is particularly preferable. It is advisable to set the conditions for the concentration of the solution, the immersion, and others appropriately. For example, the silicon substrate is immersed in a 10% aqueous solution of sodium hydroxide at room temperature. At this time, fine bubbles are generated from the silicon substrate surface. The reaction will be detailed later.

This immersion makes it possible to remove projections having a height of about 0.1 µ m or less, which block the conduction of electrons generated by light absorption.

Next, the semiconductor substrate is taken out from the alkaline solution after the generation of the bubbles stops. The semiconductor substrate is sufficiently washed with water (G-5).

It is advisable to set conditions for the water-washing appropriately. For example, the silicon substrate taken out from the alkaline solution is washed with water for about 3 minutes.

Next, the alkaline solution adhering to the semiconductor substrate is neutralized with an acidic solution or the like (G-6). It is advisable to set conditions for the neutralization appropriately. For example, the silicon substrate is immersed in a 1% or 10% aqueous solution of diluted hydrochloric acid to neutralize alkaline components in the silicon substrate surface.

About the chemical reaction on the semiconductor substrate surface in the step (G-2), the following describes contents presumed by the inventors of the present invention. A case where a silver-containing solution is used is described herein. However, in the case of using a copper-containing solution, substantially the same reaction would advance.

By action of the mixed solution of hydrofluoric acid and nitric acid, a series of reactions as described below are caused in combination with each other, so as to etch the silicon substrate surface.

First, the silicon substrate surface is oxidized with nitric acid to produce SiO₂, thereby generating nitrogen monoxide (NO).

3Si + 4H⁺ + 4NO₃⁻ → 3SiO₂ + 2H₂O + 4NO↑ (1)

In the case that silver ions (Ag⁺) are present in the solution at this time, generated nitrogen monoxide partially causes a reaction as described below.

Ag⁺ + NO₃⁻ + NO → 2NO₂↑ + Ag (2)

Silver (Ag) deposited at this time reacts with nitric acid as described in the following formula, so as to turn immediately into silver nitrate, then silver ions.

Ag + 2H⁺ + NO₃⁻ → Ag⁺ + H₂O + 2NO₂↑ (3)

In a series of the reactions (2) and (3), the silver ions in the solution are recycled, so that the concentration of the silver ions in the solution does not change.

SiO₂ formed in the silicon surface according to the reaction (1) reacts with hydrogen fluoride (HF) as follows.

SiO₂ + 4HF → SiF₄↑ + H₂O (4)

Tetrafluorosilane (SiF₄) generated reacts with hydrogen fluoride to form complex ions (hexafluorosilanoate ions: SiF₆²⁻).

SiF₄ + 2HF → 2H⁺ SiF₆²⁻ (5)

Hexafluorosilanoic acid (H₂SiF₆) shows strong acidity, and is ionized in the aqueous solution at a far higher ratio than hydrofluoric acid (HF), which is a weak acid.

When these continuous reactions are caused in the presence of a sufficient amount of nitrate ions, the silicon substrate surface is continuously etched without receiving any effect of the surface state thereof. However, when these continuous reactions are caused in a mixed solution composed of hydrofluoric acid as a main component and nitric acid, the reaction (1), which requires 3 silicon atoms and 4 nitric acid molecules, is generated only at a very low possibility since the concentration of nitrate ions is low.

From this matter, the nitrate ion concentration in the acidic solution is preferably from 0.01 to 1 mol/L.

SiO₂ formed in the silicon surface in the reaction (1) is immediately pulled off from the silicon surface through the reaction (4). At the same time, bubbles are generated. As shown in the reactions (1) to (5), the bubbles contain NO, NO₂, H₂ and SiF₄. When NO₂ in the bubbles and dissolved NO₂ in the solution are brought into contact with the silicon, the following reaction is caused.

Si + 2NO₂ → SiO₂ + 2NO↑ (6)

The phenomenon that generated NO₂ is brought into contact with the silicon takes place just near the portion where the first reaction (1) takes place in almost all cases. Accordingly, near the portion where the reaction (1) takes place, the reaction (6) takes place continuously. Silicon atoms eliminate concentrically near this portion through the subsequent reactions (2) to (4). The reaction (6), which takes place subsequently to the reactions (2) and (3), is caused at a far higher possibility than the reaction (1). Thus, about reactions for forming SiO₂ in the silicon surface, the reaction (6) takes priority. Therefore, silicon atoms are scraped off concentrically at the portion near the site where the reaction (1) takes place firstly. Thus, a difference between the portion and portions where no silicon atoms are scrapped off is generated so that irregularities (a porous layer) are formed in the silicon substrate surface. The height of the irregularities is from about 1 to 5 µ m.

In the case that the aqueous solution contains no silver ions, the reaction (2) does not take place but the following reaction, wherein hydrogen ions (H⁺) acts mainly, takes place.

2H⁺ + 2NO₃- + 2NO → 4NO₂↑ + H₂↑ (7)

In this reaction (7), NO₂ is generated in the same manner as in the reaction (2). Therein, however, the number of molecules and ions concerned therewith is required to be larger than that in the reaction (2), and further the ratio of the generation thereof is lower since nitrogen monoxide (NO) is slightly soluble in water. Accordingly, the amount of generated NO₂ relative to the number of silicon atoms concerned with the reaction (1) also becomes smaller so that a reaction corresponding to the reaction (3) does not take place.

Considering these matters, in the reactions (1) to (3) in the case that silver ions are present in the solution, a larger amount of NO₂ is generated than in the reactions (1) and (7) in the case that no silver ions are present in the solution, so that a possibility that the reaction (6) is generated becomes high. As described above, the reaction (6) gives an effect for promoting the formation of an irregularity structure in the silicon substrate surface; when a larger amount of NO₂ is brought into contact with the silicon surface portion that is once scrapped off, the formation of the irregularity structure is further promoted. On the other hand, in the case that no silver ions are present in the solution, the generation of NO₂ has a rate-determining step of the reaction (7), the reaction possibility of which is low; therefore, an irregularity structure is far less formed, as compared with the case that silver ions are present.

The following describes a principle of removing the stain layer with an alkaline solution.

By the formation of the above-mentioned irregularity structure, crepe-pattern irregularities wherein the width and the depth are each from about 0.1 to 20 µm are formed in the silicon substrate surface. However, it is presumed that besides the macroscopic irregularities, a silicon porous layer having fine irregularities the sizes of which range from 1 to 100 nm is formed in the surface layer regions of the silicon substrate. This layer is a blackened layer, so that reflection thereon is hardly observed within a range of visible light wavelengths. This silicon porous layer blocks the conduction of electrons generated by light absorption; therefore, it is necessary to remove this layer from the surface in order to obtain a solar cell properties.

In this porous layer, silicon gets radicals. Therefore, even if concentrated nitric acid is used, the reaction (1), for which 4 nitric acid molecules per 3 silicon atoms are necessary, is hardly caused. However, at room temperature, silicon reacts with an alkali as follows.

Si + 2OH + H₂O → SiO₃²⁻ + 2H₂ (8)

When the hydroxide concentration in the solution is within a specific range at this time, only the silicon porous layer is removed.

From these matters, the hydroxide ion concentration in the acidic solution is preferably from 0.025 to 2.5 mol/L, more preferably from 0.1 to 1.0 mol/L.

The silicon substrate surface from which the porous layer is removed has a surface irregularity structure wherein the surface area containing irregularities is from 1.2 to 2.2 times the surface area of the imaginary smooth face and the standard deviation of the heights of the irregularities is 1.0 µm or less; or a surface irregularity structure wherein aggregate sections of irregularities having irregularity heights ranging from 0.1 to 2 µm are mixed with sections having irregularity heights ranging from 5 to 20 µm. In the latter silicon substrate surface, the reflectivity, including scattered light, is 15% or less within a wavelength range from 500 to 1000 nm.

Any silicon substrate having such a surface irregularity structure acts normally and is electrically stable even if a pn junction is formed in its surface by phosphorus diffusion or the like.

On the basis of the above-mentioned principle, there is formed a polycrystalline silicon substrate for a solar cell having a reduced light reflectivity.

A solar cell manufactured by use of a semiconductor substrate for a solar cell manufactured by the above-mentioned method has an irregularity structure having good properties, and is low in reflectivity and high in efficiency.

### (Examples)

The present invention will be more specifically described by way of the following examples. However, the present invention is not limited to these examples.

### Example 1

A p-type polycrystalline silicon ingot, having a resistivity of 1.2 to 1.8 Ωcm and cast by a casting method, was cut into a square pole 100 mm square with a band saw. The resultant square pole was sliced into a thickness of 300 µ m with a wire saw to obtain 200 polycrystalline silicon substrates. Whenever the pole was cut into four out of the 200 polycrystalline silicon substrates, the four substrates were successively separated into 4 groups. Thus, group A, groups B, group C and group Z were obtained, in each of which the number of the substrates was 50.

The polycrystalline silicon substrates of the respective obtained groups were washed by the RCA method.

At room temperature, the polycrystalline silicon substrates of groups A and B were each immersed in a solution wherein a 60% nitric acid solution and a 50% hydrofluoric acid solution were mixed at 3/1 for 1 minute, so as to be etched into a depth of about 10 µm, thereby removing a damaged layer generated by the slicing.

Into a mixed solution of 2L of a 50% hydrofluoric acid solution and 60 mL of a 60% nitric acid solution was dissolved 5 g of pure silver powder to obtain an acidic solution. The polycrystalline silicon substrates of group A were immersed in the resultant acidic solution at room temperature for 5 minutes, and then washed with pure water for 3 minutes. The surface of the washed polycrystalline silicon substrate was blackened.

Into a mixed solution of 2L of a 50% hydrofluoric acid solution and 60 mL of a 60% nitric acid solution was dissolved 11.5 g of pure copper powder to obtain an acidic solution. The polycrystalline silicon substrates of group B were immersed in the resultant acidic solution at room temperature for 5 minutes, and then washed with pure water for 3 minutes. The surface of the washed polycrystalline silicon substrate was blackened.

Next, the polycrystalline silicon substrates of groups A and B were each immersed in a 10% aqueous solution of sodium hydroxide at room temperature. Fine bubbles were generated from the surface of the polycrystalline silicon substrate during the immersion. After the generation of the bubbles stopped, the polycrystalline silicon substrate was taken out from the aqueous solution of sodium hydroxide, and washed with pure water for 5 minutes. Thereafter, the polycrystalline silicon substrate was immersed in a 10% aqueous solution of diluted hydrochloric acid for 5 minutes to neutralize the alkaline component on the substrate surface. The resultant was again washed with pure water for 3 minutes, and dried.

These polycrystalline silicon substrates of groups A and B were each made into a solar cell through the steps F-4 to F-7 in Fig. 1.

The isotropic texturing device manufactured by RENA Sondermaschinen GMBH was used to form irregularities in each of the surfaces of the polycrystalline silicon substrates of group C by a method recommended by this company.

Irregularities were formed in each of the surfaces of the polycrystalline silicon substrates of group Z by alkali etching, which is widely used to form irregularities in single crystalline silicon substrates. Specifically, the polycrystalline silicon substrates were each immersed in a 3% aqueous solution of sodium hydroxide, having a temperature of 85 to 90°C, for 20 minutes, and further immersed in a 10% aqueous solution of diluted hydrochloric acid for 10 minutes to neutralize the alkaline component on the substrate surface, thereby forming irregularities in the substrate surface.

These polycrystalline silicon substrates of groups C and Z were each made into a solar cell through the steps F-4 to F-7 in Fig. 1.

Properties of the solar cells of each of groups were measured in accordance with a method prescribed in JIS C 8913 (Measuring method of output power for crystalline solar cells).

The "surface area containing irregularities" and the "standard deviation of the heights of the irregularities" of each of the semiconductor substrates were measured by use of a confocal laser scanning microscope using a semiconductor laser light having a wavelength of 408 nm, such as a microscope, model No. LEXT OLS3000, manufactured by Olympus Corporation. Specifically, from the surface of the semiconductor substrate, 16 points were selected at will. The above-mentioned microscope with an objective lens of 100 magnifications was used under 1-power optical zooming in an enhancing mode to take in height data on its surface irregularities in a step search manner at a height resolving power of 0.01 µ m. The resultant height data on the irregularities were subjected to smoothing correction one time along an XY direction in a median mode with a mask size of 5. In this way, measurement noises were removed. In accordance with a grain analysis menu, the "surface area containing irregularities" and the "surface area of the imaginary smooth face" were obtained, and in accordance with a surface roughness menu, the "standard deviation (SRq) of the heights of the irregularities" was obtained. These operations were repeated about the 16 measured points. The respective averages of the resultant numerical values were used as the "surface area containing irregularities (in Table 1, it is shown as base area)", the "surface area of the imaginary smooth face (in Table 1, it is shown as surface area)", and the "standard deviation (SRq) of the heights of the irregularities".

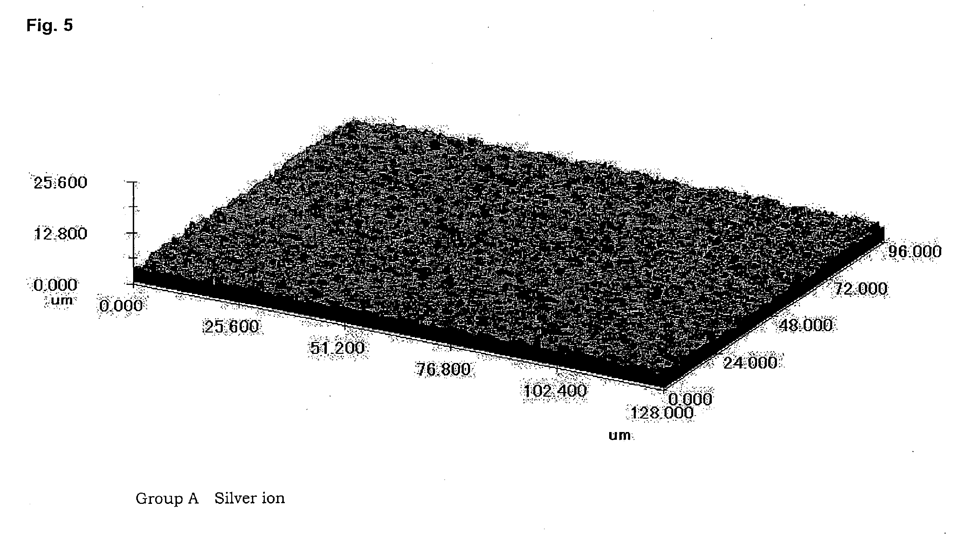

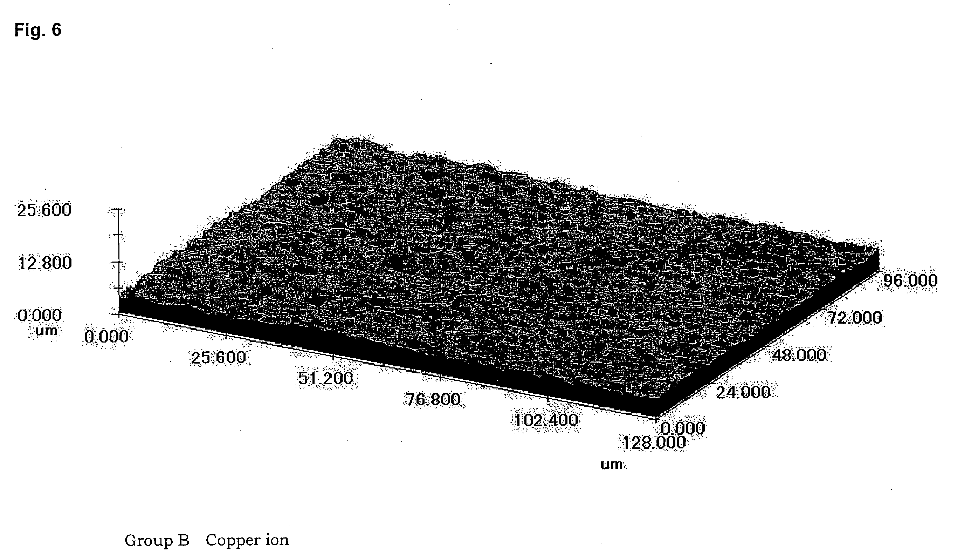

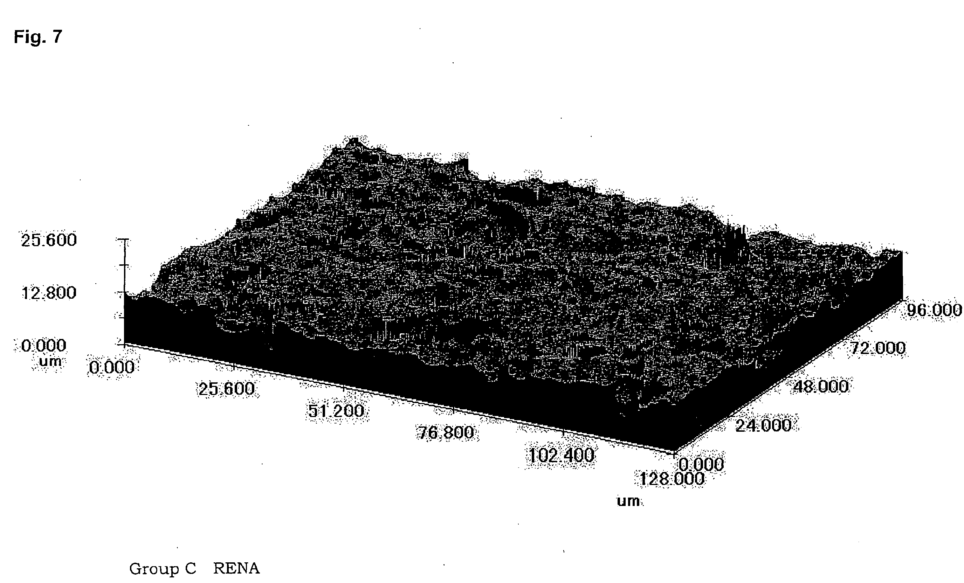

The measured results are shown in Table 1 and Figs. 5 to 7.

Figs. 5 to 7 are graphics showing the typical bird's eye observation images of the surfaces of the polycrystalline silicon substrates of group A, group B and group C, respectively.

**[Table 1]**

| Group | Method | Short circuit current (A) | Open Circuit current (V) | Fill factor (%) | Conversion efficiency (%) | Surface area/base area | Standard deviation of heights (µm) |
|---|---|---|---|---|---|---|---|
| A | Silver ions | 3.18 | 0.614 | 77.5 | 15.1 | 1.44 | 0.45 |
| B | Copper ions | 3.16 | 0.613 | 77.2 | 15.0 | 1.35 | 0.50 |
| C | RENA GMBH | 3.17 | 0.609 | 75.8 | 14.6 | 1.47 | 1.40 |
| Z | Alkali | 3.09 | 0.613 | 74.9 | 14.2 | 1.17 | 0.89 |

From these experiment results, it is understood that the polycrystalline silicon substrates of groups A, B and C are each have a surface area 1.4 times the base area so as to exhibit an excellent effect of preventing light reflection, and thus similar short circuit currents are obtained.

From Figs. 5 to 7, it is understood that the polycrystalline silicon substrates of groups A, B and C each have formed irregularity shapes necessary for preventing light reflection.

As compared with the polycrystalline silicon substrates of groups A and B, each of the polycrystalline silicon substrates of group C has larger irregularity undulations on its surfaces. Thus, when electrodes are formed on its substrate surface, steps that cannot be neglected are generated, in the direction along which electric current flows, in the electrodes. As a result, the electric resistance somewhat increases.

For this reason, the solar cells of groups A and B have a better fill factor and give a higher conversion efficiency than the solar cells of group C.

About the polycrystalline silicon substrates of group Z, the ratio of the surface area to the base area, and the standard deviation of the heights each exhibit a large scattering, depending on locations, and thus the effect of preventing light reflection is insufficient. Furthermore, the steps of the electrodes are large in number, and thus the electric resistance increases and the fill factor becomes a low value.

### Example 2

In the same way as in Example 1, 250 polycrystalline silicon substrates were obtained. Whenever five out of the 250 polycrystalline silicon substrates was cut off, the five substrates were successively separated into 5 groups. Thus, group A, group D, group E, group F and group Z were obtained, in each of which the number of the substrates was 50. The polycrystalline silicon substrates of the resultant respective groups were washed by the RCA method.

Thereafter, in the same way as in Example 1, at room temperature the polycrystalline silicon substrates of groups A, D, E and F were each immersed in a solution wherein a 60% nitric acid solution and a 50% hydrofluoric acid solution were mixed at 3/1 for 1 minute, so as to be etched into a depth of about 10 µm, thereby removing a damaged layer generated by the slicing.

Into a mixed solution of 2L of a 50% hydrofluoric acid solution and 60 mL of a 60% nitric acid solution was dissolved 5 g of pure silver powder to obtain an acidic solution. The polycrystalline silicon substrates of group A were each immersed in the resultant acidic solution at room temperature for 5 minutes, and then washed with pure water for 3 minutes. The surface of the washed polycrystalline silicon substrate was blackened.

Into a mixed solution of 2L of a 50% hydrofluoric acid solution and 60 mL of a 60% nitric acid solution was dissolved 10 g of pure silver powder to obtain an acidic solution. The polycrystalline silicon substrates of group E were each immersed in the resultant acidic solution at room temperature for 5 minutes, and then washed with pure water for 3 minutes. The surface of the washed polycrystalline silicon substrate was blackened.

In the same way as in Example 1, the polycrystalline silicon substrates of groups A and E were used to produce solar cells.

Into a mixed solution of 2L of a 50% hydrofluoric acid solution and 60 mL of a 60% nitric acid solution was dissolved 1 g of pure silver power to obtain an acidic solution. The polycrystalline silicon substrates of group D were each immersed in the resultant acidic solution at room temperature for 5 minutes, and then washed with pure water for 3 minutes. The surface of the washed polycrystalline silicon substrate was blackened.

Into a mixed solution of 2L of a 50% hydrofluoric acid solution and 60 mL of a 60% nitric acid solution was dissolved 20 g of pure silver powder to obtain an acidic solution. The polycrystalline silicon substrates of group F were each immersed in the resultant acidic solution at room temperature for 5 minutes, and then washed with pure water for 3 minutes. The surface of the washed polycrystalline silicon substrate was blackened.

In the same way as in Example 1, irregularities were formed in the surfaces of the polycrystalline silicon substrates of group Z by alkali etching.

In the same way as in Example 1, the polycrystalline silicon substrates of groups D, F and Z were used to produce solar cells.

In the same way as in Example 1, properties of the solar cells of each of the groups, the surface area of the semiconductor substrate surface thereof, and the standard deviation of the heights thereof were measured.

The measured results are shown in Table 2.

| | | | | | | | |
|---|---|---|---|---|---|---|---|
| [Table 2] | | | | | | | |

| Group | Method | Short circuit current (A) | Open Circuit voltage (V) | Fill factor (%) | Conversion efficiency (%) | Surface area/base area | Standard deviation of heights (µm) |
|---|---|---|---|---|---|---|---|
| A | 5 | 3.18 | 0.614 | 77.5 | 15.1 | 1.44 | 0.45 |
| D | 1 | 3.02 | 0.613 | 76.9 | 14.2 | 1.12 | 0.31 |
| E | 10 | 3.19 | 0.609 | 75.8 | 14.7 | 2.07 | 0.76 |
| F | 20 | 3.08 | 0.597 | 73.2 | 13.4 | 2.33 | 0.81 |
| Z | - | 3.09 | 0.613 | 74.9 | 14.2 | 1.17 | 0.89 |

From Table 2, it is understood that in the case that the ratio of the surface area/the base area is less than 1.2 times or more than 2.2 times, the effect of improving the conversion efficiency is far lower than in the case of the solar cells of the polycrystalline silicon substrates of group Z treated by the method in the prior art.

The present invention is concerned with Japanese Patent Application No. 2004-159721 filed on May 28, 2004, and the present application therefor is filed with a priority claim thereof. The content thereof is incorporated herein for reference.

## Claims

1. A semiconductor substrate for a solar cell, comprising the semiconductor substrate having a surface which constitutes a light incident face of the solar cell and having a surface irregularities structure, wherein the surface has an surface area from 1.2 to 2.2 times that of an imaginary smooth face and the standard deviation of the heights of the irregularities is 1.0 µm or less.

2. A semiconductor substrate for solar cell according to claim 1, wherein the semiconductor substrate is polycrystalline silicon substrate.

3. A solar cell manufactured by use of the semiconductor substrate for solar cell as set forth in claim 1 or 2.

4. A method for manufacturing a semiconductor substrate for a solar cell, comprising the step of subjecting the semiconductor substrate successively to immersing treatment in an acid solution containing silver ions or copper ions, fluoride ions, and nitrate ions, water-washing treatment, immersing treatment in an alkaline solution, and water-washing treatment, thereby obtaining the semiconductor substrate for solar cell as set forth in claim 1.

5. A method for manufacturing a semiconductor substrate for a solar cell according to claim 4, wherein the alkaline solution is an aqueous solution containing one or more selected from sodium hydroxide, potassium hydroxide, ammonium hydroxide, hydrazine, sodium carbonate and potassium carbonate.
